# EUROPEAN PATENT APPLICATION

(11) **EP 4 411 792 A1**
(43) Date of publication of application: **07.08.2024**
(21) Application number: 22875773.8
(22) Date of filing: 08.09.2022
(51) Int. Cl.: H01L 21/52, B23K 35/14, B23K 35/26, C22C 13/02

(54) **BONDING MATERIAL AND SEMICONDUCTOR PACKAGE**

(30) Priority: 30.09.2021 JP 2021162429
(71) Applicant: Tamura Corporation, Tokyo 178-8511 (JP)
(72) Inventor: NARUSE, Shouichirou, Iruma-shi Saitama 358-0032 (JP); NAKANO, Takeshi, Iruma-shi Saitama 358-0032 (JP); SAKAMOTO, Isao, Iruma-shi Saitama 358-0032 (JP); SHIMADA, Toshiaki, Iruma-shi Saitama 358-0032 (JP); OKUBO, Koichi, Iruma-shi Saitama 358-0032 (JP)
(74) Representative: Cabinet Beau de Loménie
(86) International application number: PCT/JP2022/033808
(87) International publication number: WO 2023/053901

(57) **Abstract**

A bonding material capable of suppressing occurrence of a crack in a bonding portion and suppressing occurrence of a crack in a semiconductor element even in a case where a particularly high temperature is loaded, a bonding material including a base material portion and a solder layer covering the upper surface and the lower surface of the base material portion, in which the base material portion comprises a core base material, and a first metal layer and a second metal layer provided on at least one surface of the core base material in this order from the side of the core base material, and the solder layer comprises a solder alloy comprising 1% by mass or more and 8% by mass or less of Cu, 10% by mass or more and 30% by mass or less of Sb, 0.01% by mass or more and 0.5% by mass or less of Ni, and 0.001% by mass or more and 0.5% by mass or less of Co, with the balance being Sn.

## Description

### Technical Field

The present invention relates to a bonding material and a semiconductor package.

### Background Art

A semiconductor package used for an electronic device is manufactured by bonding (die-bonding) a semiconductor element on a substrate using a bonding material, and molding it with a molding resin or the like after subjecting to wire bonding or the like. In recent years, applications of a power semiconductor package using a so-called power semiconductor element capable of handling a high voltage and a large current in the semiconductor package are increasing.

As a power semiconductor element used in this power semiconductor package, a Si element has been widely used conventionally. However, with the recent improvement in performance of power semiconductor packages, the use of power semiconductor elements, for example, SiC elements, GaN elements, and Ga₂O₃ elements and the like, which have higher performance and can handle higher voltages and larger currents, also tends to increase.

The SiC element, the GaN element, the Ga₂O₃ element, and the like are superior in heat resistance to the Si element, and the operating temperature thereof is also high. Therefore, the heat resistant temperature of the power semiconductor package using these can be changed from the conventional 150°C to, for example, 175°C or 200°C.

On the other hand, as the operating temperature of the power semiconductor element rises, the temperature loaded on a bonding portion (formed using a bonding material) also rises. As a result, since the temperature of the bonding portion itself also increases, stress caused by a difference in linear expansion coefficient between the substrate and the power semiconductor element concentrates on the bonding portion, and cracks are more likely to occur in the bonding portion.

Here, a high-lead solder such as Sn-95Pb has been conventionally used for bonding the Si element to the substrate. However, in recent years, environmental pollution by lead has become a problem, and therefore, it is desired to use a so-called lead-free solder that avoids the use of lead.

As the lead-free solder, Sn-Ag-based alloys, Sn-3.0Ag-0.5Cu-based alloys, and Sn-Sb-based alloys are widely used. However, since the bonding portion formed using these alloys cannot absorb stress due to a difference in linear expansion coefficient from that of the Si element, it is difficult to suppress cracks caused by this.

Patent Literature 1 discloses, as a bonding material capable of suppressing occurrence of cracks in such a bonding portion, a laminated bonding material in which a linear expansion coefficient of a base material is 5.5 to 15.5 ppm/K, a first surface and a second surface are coated with a lead-free solder, the base material comprises any one of a Cu-W base material, a Cu-Mo base material, and a laminated material of a Cu-W base material and a Cu-Mo base material, and an interface between the lead-free solder and at least one of the first surface and the second surface of the base material is subjected to base treatment with Ni and Sn in order from the side of the base material.

### Citation List

### Patent Literature

Patent Literature 1: JP 6871524 B2

### Summary of Invention

### Technical Problem

According to Patent Literature 1, it is possible to alleviate distortion generated in a bonding portion under a high temperature environment. However, in a general semiconductor package, a semiconductor element generates heat during operation, and this heat is transferred to the entire semiconductor package and dissipated to the outside via a heat dissipation substrate. Therefore, under a high temperature environment as described in Patent Literature 1, a load due to short-time heating and heat dissipation is also generated in the lead-free solder, so that there remains a load on the lead-free solder itself and a risk that a solder layer crack is generated due to the load.

Furthermore, in such a laminated bonding material, there are also methods such as blending Ag for the purpose of precipitation strengthening. However, even in such a case, stress generated at the interface between the lead-free solder and the semiconductor element may cause cracks in the semiconductor element.

Furthermore, the thermal conductivity of the Sn-based alloy comprising Sn as a main component is low, and the ability of the bonding portion formed using such an alloy to diffuse heat generated in the power semiconductor element is also low. Therefore, the time during which the bonding portion is exposed to the stress due to the linear expansion coefficient becomes longer, and as a result, the crack of the bonding portion is more likely to occur. The occurrence of such cracks is neither disclosed nor suggested in Patent Literature 1.

An object of the present invention is to solve the above problems, and an object thereof is to provide a bonding material and a semiconductor package capable of suppressing occurrence of a crack in a bonding portion and suppressing occurrence of a crack in a semiconductor element even in a case where a particularly high temperature is loaded.

### Solution to Problem

A bonding material of the present invention comprises a base material portion and a solder layer covering the upper surface and the lower surface of the base material portion, in which the base material portion comprises a core base material, and a first metal layer and a second metal layer provided on at least one surface of the core base material in this order from the side of the core base material, and the solder layer comprises a solder alloy comprising 1% by mass or more and 8% by mass or less of Cu, 10% by mass or more and 30% by mass or less of Sb, 0.01% by mass or more and 0.5% by mass or less of Ni, and 0.001% by mass or more and 0.5% by mass or less of Co, with the balance being Sn.

In the bonding material of the present invention, the solder alloy preferably further comprises 0.1% by mass or more and less than 3% by mass of Ag.

In the bonding material of the present invention, the solder alloy preferably further comoprises at least one of Al, Ti, Si, Fe, and Ge.

In the bonding material of the present invention, contents (% by mass) of Cu and Ni in the solder alloy preferably satisfy Formula (A) below. Ni content (% by mass) / (Cu content (% by mass) + Ni content (% by mass)) < 0.1

In the bonding material of the present invention, the core base material preferably has a linear expansion coefficient of 25 ppm/K or less.

In the bonding material of the present invention, the core base material preferably has a thermal conductivity of 25 W/(m·K) or more.

In the bonding material of the present invention, the first metal layer preferably consists of any one of Ni, Sn, Cu, Au, and Ag.

In the bonding material of the present invention, the second metal layer preferably comprises at least one of a Sn-Ni-based intermetallic compound, a Sn-Ag-based intermetallic compound, a Sn-Cu-based intermetallic compound, and a Sn-Au-based intermetallic compound.

Furthermore, a semiconductor package of the present invention comprises a substrate, a semiconductor element, and a bonding portion that bonds the substrate and the semiconductor element, in which the bonding portion is formed using a bonding material, the bonding material comprises a base material portion and a solder layer covering the upper surface and the lower surface of the base material portion, the base material portion comprises a core base material, and a first metal layer and a second metal layer provided on at least one surface of the core base material in this order from the side of the core base material, and the solder layer comprises a solder alloy comprising 1% by mass or more and 8% by mass or less of Cu, 10% by mass or more and 30% by mass or less of Sb, 0.01% by mass or more and 0.5% by mass or less of Ni, and 0.001% by mass or more and 0.5% by mass or less of Co, with the balance being Sn.

In the semiconductor package of the present invention, the solder alloy preferably further comprises 0.1% by mass or more and less than 3% by mass of Ag.

In the semiconductor package of the present invention, the solder alloy preferably further comprises at least one of Al, Ti, Si, Fe, and Ge.

In the semiconductor package of the present invention, contents (% by mass) of Cu and Ni in the solder alloy preferably satisfy Formula (A) below. Ni content (% by mass) / (Cu content (% by mass) + Ni content (% by mass)) < 0.1

In the semiconductor package of the present invention, the core base material preferably has a linear expansion coefficient of 25 ppm/K or less.

In the semiconductor package of the present invention, the core base material preferably has a thermal conductivity of 25 W/(m·K) or more.

In the semiconductor package of the present invention, the first metal layer preferably consists of any one of Ni, Sn, Cu, Au, and Ag.

In the semiconductor package of the present invention, the second metal layer preferably comprises at least one of an Sn-Ni-based intermetallic compound, an Sn-Ag-based intermetallic compound, an Sn-Cu-based intermetallic compound, and an Sn-Au-based intermetallic compound.

Furthermore, as another aspect of the semiconductor package of the present invention, a power semiconductor package is preferable.

Such a power semiconductor package of the present invention comprises a substrate, a power semiconductor element, and a bonding portion that bonds the substrate and the power semiconductor element, in which the bonding portion is formed using a bonding material, the bonding material comprises a base material portion and a solder layer covering the upper surface and the lower surface of the base material portion, the base material portion comprises a core base material, and a first metal layer and a second metal layer provided on at least one surface of the core base material in this order from the side of the core base material, and the solder layer comprises a solder alloy comprising 1% by mass or more and 8% by mass or less of Cu, 10% by mass or more and 30% by mass or less of Sb, 0.01% by mass or more and 0.5% by mass or less of Ni, and 0.001% by mass or more and 0.5% by mass or less of Co, with the balance being Sn.

In such a power semiconductor package, the solder alloy preferably further comprises 0.1% by mass or more and less than 3% by mass of Ag.

In such a power semiconductor package, the solder alloy preferably further comprises at least one of Al, Ti, Si, Fe, and Ge.

In such a power semiconductor package, contents (% by mass) of Cu and Ni in the solder alloy preferably satisfy Formula (A) below. Ni content (% by mass) / (Cu content (% by mass) + Ni content (% by mass)) < 0.1

In such a power semiconductor package, the core base material preferably has a linear expansion coefficient of 25 ppm/K or less.

In such a power semiconductor package, the core base material preferably has a thermal conductivity of 25 W/(m·K) or more.

In such a power semiconductor package, the first metal layer preferably consists made of any one of Ni, Sn, Cu, Au, and Ag.

In such a power semiconductor package, the second metal layer preferably comprises at least one of an Sn-Ni-based intermetallic compound, an Sn-Ag-based intermetallic compound, an Sn-Cu-based intermetallic compound, and an Sn-Au-based intermetallic compound.

A method of manufacturing a bonding material of the present invention is a method of manufacturing a bonding material including a base material portion and a solder layer covering the upper surface and the lower surface of the base material portion, the base material portion including a core base material, and a first metal layer and a second metal layer provided on at least one surface of the core base material in this order from the side of the core base material, the method including: a first metal layer forming step of forming the first metal layer on at least one surface of the upper surface and the lower surface of the core base material; and a solder layer forming step of forming the solder layer on the outermost surface of the first metal layer and a surface side of the core base material on which the first metal layer is not formed, or on both outermost surfaces of the first metal layer, in which in the solder layer forming step, the solder layer is formed using a solder alloy comprising 1% by mass or more and 8% by mass or less of Cu, 10% by mass or more and 30% by mass or less of Sb, 0.01% by mass or more and 0.5% by mass or less of Ni, and 0.001% by mass or more and 0.5% by mass or less of Co, with the balance being Sn, and further, the second metal layer is formed at an interface between the first metal layer and the solder layer.

In the method of manufacturing a bonding material, in the solder layer forming step, a third metal layer may be formed at an interface between a surface of the core base material on which the first metal layer is not formed and the solder layer.

A bonding method of the present invention is a method of bonding a substrate and a semiconductor element using a bonding material in a semiconductor package including the substrate and the semiconductor element, the bonding material including a base material portion and a solder layer covering the upper surface and the lower surface of the base material portion, in which the base material portion comprises a core base material, and a first metal layer and a second metal layer provided on at least one surface of the core base material in this order from the side of the core base material, and the solder layer comprises a solder alloy comprising 1% by mass or more and 8% by mass or less of Cu, 10% by mass or more and 30% by mass or less of Sb, 0.01% by mass or more and 0.5% by mass or less of Ni, and 0.001% by mass or more and 0.5% by mass or less of Co, with the balance being Sn.

A method of manufacturing a semiconductor package of the present invention comprises the steps of: disposing a bonding material on a substrate; disposing a semiconductor element on the bonding material; and heating the substrate, the bonding material, and the semiconductor element to form a bonding portion for bonding the substrate and the semiconductor element, in which the bonding material comprises a base material portion and a solder layer covering the upper surface and the lower surface of the base material portion, in which the base material portion comprises a core base material, and a first metal layer and a second metal layer provided on at least one surface of the core base material in this order from the side of the core base material, and the solder layer comprises a solder alloy comprising 1% by mass or more and 8% by mass or less of Cu, 10% by mass or more and 30% by mass or less of Sb, 0.01% by mass or more and 0.5% by mass or less of Ni, and 0.001% by mass or more and 0.5% by mass or less of Co, with the balance being Sn.

### Advantageous Effects of Invention

A bonding material and a semiconductor package of the present invention can suppress the occurrence of cracks in a bonding portion and can suppress the occurrence of cracks in a semiconductor element even in a case where a particularly high temperature is loaded.

### Brief Description of Drawings

Fig. 1 is a schematic cross-sectional view illustrating a bonding material according to the first embodiment.
Fig. 2 is a schematic cross-sectional view illustrating a bonding material according to the second embodiment.
Fig. 3 is a schematic cross-sectional view illustrating a semiconductor package according to the present embodiment.
Fig. 4 is a schematic cross-sectional view illustrating a test bonding material used in each test according to Examples and Comparative Examples.
Fig. 5 is an electron micrograph representing a part of a cross section of a test bonding material (Example 10) including a first metal layer and a second metal layer in Example.
Fig. 6 is a temperature profile representing reflow temperature conditions at the time of preparing a test bonded body used in each test according to Examples and Comparative Examples.
Fig. 7 is an example of an image obtained by imaging a test bonded body used in Examples using an ultrasonic microscope, in which (a) represents a bonding interface image (image A) captured from the Si chip side, and (b) represents a bonding interface image (image B) captured from the substrate side.

### Description of Embodiments

Hereinafter, one embodiment of a bonding material and a semiconductor package of the present invention will be described in detail. It is needless to say that the present invention is not limited to the embodiment.

### 1. Bonding Material

### (First Embodiment)

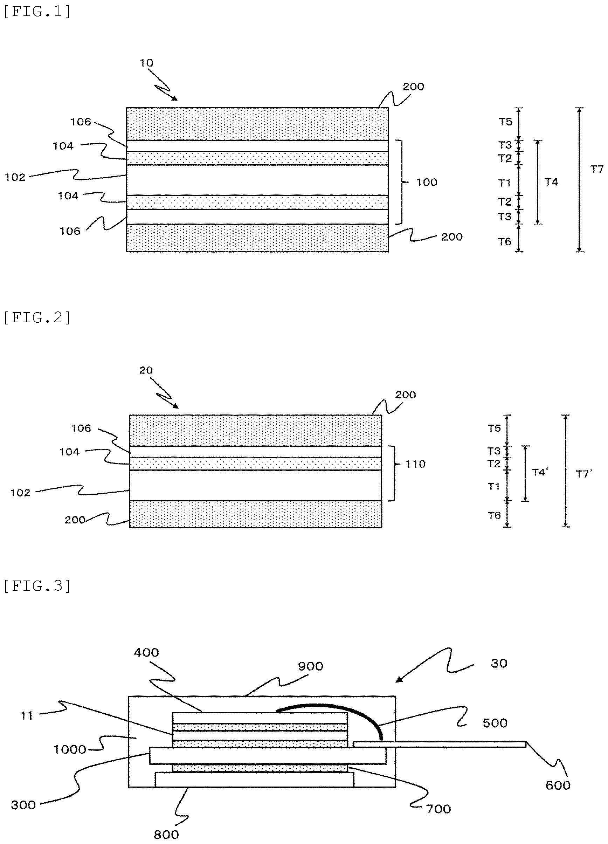

A configuration of one embodiment (first embodiment) of the bonding material of the present invention will be described with reference to Fig. 1. That is, the bonding material 10 comprises a base material portion 100 and a solder layers 200, 200. The solder layers 200, 200 cover the upper surface and thelower surface of the base material portion 100.

### · Base Material Portion 100

The base material portion 100 comprises a core base material 102, first metal layers 104, 104, and second metal layers 106, 106. Specifically, the first metal layers 104, 104 and the second metal layers 106, 106 are provided on the upper surface and the lower surface of the core base material 102 in this order from the side of the core base material 102.

### · Core Base Material 102

In the core base material 102, for example, a bonding portion (A bonding portion formed using the bonding material is hereinafter referred to as a "bonding portion".) formed using the bonding material 10 bonds a bonding material to be bonded, for example, a substrate and a semiconductor element, and in a case where a high temperature is loaded on the bonding portion, a difference in linear expansion coefficient between the substrate and the semiconductor element can be alleviated.

Examples of such core base material 102 comprises those made of any of W, Mo, CuMo, Ni, Fe, SUS430, Au, Cu, Ag, and Al. CuMo having a Cu content of 15% by mass or more and 60% by mass or less is preferably used, and CuMo having a Cu content of 30% by mass or more and 40% by mass or less is more preferably used.

In consideration of the balance between a linear expansion coefficient of the substrate and a linear expansion coefficient of the semiconductor element, a linear expansion coefficient of the core base material 102 is preferably 25 ppm/K or less.

The linear expansion coefficient of the core base material 102 is more preferably 20 ppm/K or less, and still more preferably 15 ppm/K or less. Furthermore, the linear expansion coefficient is particularly preferably 4 ppm/K or more and 9 ppm/K or less.

In the present specification, the linear expansion coefficient is measured on the basis of JIS standard Z2285:2003 (method of measuring linear expansion coefficient of metal material).

Furthermore, as the core base material 102, one having a thermal conductivity of 25 W/(m·K) or more is preferably used. In a case where the thermal conductivity of the core base material 102 is in this range, in the semiconductor package incorporating said core base material, heat generated from the semiconductor element is easily discharged from the substrate side to the outside, and a thermal load on the bonding portion can be reduced.

The thermal conductivity of the core base material 102 is more preferably 100 W/(m-K) or more, and still more preferably 140 W/(m·K) or more and 420 W/(m·K) or less.

In the present specification, the thermal conductivity is measured on the basis of JIS standard R1611:2010 using a laser flash method.

In a case where the core base material 102 having the linear expansion coefficient within the above range and/or the thermal conductivity within the above range is used, cracks generated in the bonding portion can be further suppressed.

The thickness (T1) of the core base material 102 is preferably 10 um or more and 200 um or less. T1 is more preferably 50 um or more and 150 um or less.

### · First Metal Layer 104

The first metal layer 104 can improve adhesion in the bonding material 10, particularly adhesion between the core base material 102 and the solder layer 200. Then, due to this improvement in adhesion, the bonding portion can further reduce a difference in linear expansion coefficient between the substrate and the semiconductor element, and heat generated from the semiconductor element can be more easily diffused to the outside. Then, as a result, the reliability of the bonding portion can be improved.

The first metal layer 104 preferably consists of Ni, Sn, Cu, Au, or Ag. The first metal layer 104 is formed by, for example, laminating Ni, Sn, Cu, Au or Ag on the core base material 102 (in the case of the present embodiment, the upper surface and the lower surface) by a conventional surface treatment method such as a plating treatment method or a coating treatment method. The first metal layer 104 having such a configuration can further improve adhesion between the core base material 102 and the solder layer 200.

The thickness (T2) of the first metal layer 104 is preferably 0.5 um or more and 10 um or less. T2 is more preferably 1 um or more and 8 um or less. The thickness of the first metal layer 104 laminated on the upper surface of the core base material 102 and the thickness of the first metal layer 104 laminated on the lower surface of the core base material 102 may be the same or different.

### · Second Metal Layer 106

The second metal layer 106 together with the first metal layer 104 can improve adhesion in the bonding material 10, particularly adhesion between the core base material 102 and the solder layer 200, and improve reliability of the bonding portion.

For example, when the solder layer 200 is formed on the upper surface and the lower surface of the base material portion 100 using a solder alloy described later, the second metal layer 106 is a layer made of a precipitate (intermetallic compound) of a metal constituting the first metal layer 104 and an element comprised in the solder alloy, and is formed at an interface between the first metal layer 104 and the solder layer 200.

For example, in a case where the first metal layer 104 is formed using any of Ni, Sn, Cu, and Ag, the second metal layer 106 comprises at least one of an Sn-Ni-based intermetallic compound, an Sn-Ag-based intermetallic compound, and an Sn-Cu-based intermetallic compound.

Furthermore, in a case where the first metal layer 104 is formed using Au, the second metal layer 106 comprises at least one of an Sn-Ni-based intermetallic compound, an Sn-Ag-based intermetallic compound, an Sn-Cu-based intermetallic compound, and an Sn-Au-based intermetallic compound.

The second metal layer 106 comprising such an intermetallic compound can further improve adhesion between the core base material 102 and the solder layer 200.

Examples of the intermetallic compound comprise (Sn,Sb)-Ni intermetallic compound, (Sn,Sb)-Ag intermetallic compound, and (Sn,Sb)-(Cu,Ni,Co) intermetallic compound.

However, the intermetallic compound constituting the second metal layer 106 is not limited thereto, and varies depending on the types of the metal constituting the first metal layer 104 and elements comprised in the solder alloy.

The method of forming the second metal layer 106, that is, the method of forming the solder layer 200 may be any method as long as an intermetallic compound can be precipitated at an interface between the first metal layers 104, 104 and the solder layers 200, 200.

For example, examples thereof comprise a method of forming the solder layer 200 by plating, coating, or the like of a solder alloy on the upper surface and the lower surface of the base material portion 100 (conventional surface treatment method), that is, a surface of the first metal layer 104 (which is not in contact with the core base material 102. The same applies hereinafter.), as well as a method of forming the solder layer 200 by rolling (hot rolling, cold rolling) or the like of a solder alloy formed into a sheet on the first metal layer 104.

Furthermore, for example, a method in which a volatile adhesive is applied to the surface of the first metal layers 104, 104, a solder alloy formed into a sheet is attached to the adhesive, and the adhesive is subjected to heat treatment or the like may also be adopted.

A thickness (T3) of the second metal layer 106 is preferably 0.5 um or more and 10 um or less. T3 is more preferably 1 um or more and 8 um or less. The thickness of the second metal layer 106 present on the upper surface side of the core base material 102 and the thickness of the second metal layer 106 present on the lower surface side of the core base material 102 may be the same or different. T3 can be appropriately adjusted by adjusting conditions for forming the solder layer 200, for example, temperature, time, and the like.

The thickness (T4) of the base material portion 100 is preferably 12 um or more and 240 um or less. T4 is more preferably 50 um or more and 190 um or less.

### · Solder Layer 200

The solder layer 200 is made of a solder alloy comprising 1% by mass or more and 8% by mass or less of Cu, 10% by mass or more and 30% by mass or less of Sb, 0.01% by mass or more and 0.5% by mass or less of Ni, and 0.001% by mass or more and 0.5% by mass or less of Co, with the balance being Sn. Such a solder layer 200 is formed by the above-described method of forming the solder layer 200 using the solder alloy.

In the solder layer 200 having such a configuration, the second metal layer 106 can be formed at the interface between the first metal layer 104 and the solder layer 200.

### (Solder Alloy)

When the solder alloy contains Cu in an amount of 1% by mass or more and 8% by mass or less, a Cu₆Sn₅ intermetallic compound or the like can be precipitated in the solder layer 200 after bonding (hereinafter, this is referred to as a "solder joint".), and the strength of the solder joint can be improved.

Furthermore, the content of Cu is preferably 2% by mass or more and 8% by mass or less, and more preferably 3% by mass or more and 5% by mass or less. By setting the content of Cu within this range, the strength of the solder joint can be further improved.

When the solder alloy comprises 10% by mass or more and 30% by mass or less of Sb, the solid solution strengthening of Sb in the solder joint can be improved, and the SbSn intermetallic compound and the like can be precipitated in the solder joint to improve the strength of the solder joint.

Furthermore, the Sb content is preferably 10% by mass or more and 20% by mass or less, and more preferably 10% by mass or more and 15% by mass or less. By setting the content of Sb within this range, the solid solution strengthening of Sb in the solder joint and the strength of the solder joint can be further improved.

When the solder alloy comprises Ni in an amount of 0.01% by mass or more and 0.5% by mass or less, a (Cu,Ni)₆Sn₅ intermetallic compound having a fine structure can be precipitated in the solder joint, and the strength of the solder joint can be improved. Furthermore, in this case, occurrence of a Ni erosion phenomenon described later can also be suppressed.

Furthermore, the content of Ni is preferably 0.05% by mass or more and 0.4% by mass or less, and more preferably 0.1% by mass or more and 0.3% by mass or less. By setting the content of Ni within this range, the strength of the solder joint can be further improved, and the Ni erosion phenomenon can be further suppressed.

When the solder alloy comprises Co in an amount of 0.001% by mass or more and 0.5% by mass or less, a (Cu,Co)₆Sn₅ intermetallic compound having a fine structure is precipitated in the solder joint, and the strength of the solder joint can be further improved. Furthermore, in this case, the occurrence of the Ni erosion phenomenon can be further suppressed.

Furthermore, the content of Co is preferably 0.05% by mass or more and 0.4% by mass or less, and more preferably 0.1% by mass or more and 0.35% by mass or less. By setting the content of Co within this range, the strength of the solder joint can be further improved, and the Ni erosion phenomenon can be further suppressed.

Then, since the solder layer 200 has the above configuration, the solder joint has good strength, so that it is possible to suppress the occurrence of cracks in the bonding portion, particularly in the solder joint, even in a case where a high temperature is loaded on the bonding portion.

Furthermore, the solder joint can also suppress the occurrence of a crack in the semiconductor element caused by stress generated at an interface between the solder joint and the semiconductor element.

Here, in a semiconductor element in which Ni deposition is formed on an outermost surface, particularly in a power semiconductor element, a so-called Ni erosion phenomenon is likely to occur when or after the power semiconductor element is bonded to a substrate. The Ni erosion phenomenon refers to a phenomenon in which Ni deposition existing on the outermost surface of the semiconductor element is diffused toward the bonding portion due to a high temperature load on the bonding portion. As this phenomenon progresses, adhesion between the semiconductor element and the bonding portion is reduced, and the semiconductor element is peeled off from the bonding portion.

However, as described above, since the solder layer 200 has the above configuration, the solder joint can suppress diffusion of the Ni deposition to a side of the bonding portion. Therefore, the bonding portion formed using the bonding material 10 can suppress the occurrence of the Ni erosion phenomenon, and can suppress a decrease in adhesion between the semiconductor element and the bonding portion.

Furthermore, the contents (% by mass) of Cu and Ni in the solder alloy preferably satisfy Formula (A) below. Ni content (% by mass) / (Cu content (% by mass) + Ni content (% by mass)) < 0.1

The solder layer 200 made of a solder alloy comprising Cu and Ni in this range can particularly further improve the strength of the solder joint. Furthermore, in this case, the occurrence of the Ni erosion phenomenon described above can be further suppressed.

Furthermore, the contents (% by mass) of Cu and Ni in the solder alloy more preferably satisfy Formula (A') described below. 0.03 < Ni content (% by mass) / (Cu content (% by mass) + Ni content (% by mass)) < 0.09

The value obtained from the above-described Formulas (A) and (A)' is rounded off the fourth decimal place.

Furthermore, the solder alloy may further comprise 0.1% by mass or more and less than 3% by mass of Ag.

In a case where the solder alloy comprises Ag in an amount of 0.1% by mass or more and less than 3% by mass, an Ag₃Sn intermetallic compound is precipitated in the solder joint, so that the residual stress in the solder joint can be reduced. Thus, the mechanical strength of the solder joint can be improved.

Furthermore, the content of Ag is preferably 0.1% by mass or more and 2% by mass or less, and more preferably 0.5% by mass or more and 1.5% by mass or less. By setting the content of Ag within this range, the mechanical strength of the solder joint can be further improved.

Furthermore, the solder alloy may further comprise at least one of Al, Ti, Si, Fe, and Ge. In a case where the solder alloy comprises at least one of Al, Ti, Si, Fe, and Ge, the strength of the solder joint can be further improved.

The total content of at least one of Al, Ti, Si, Fe, and Ge is preferably 0.003% by mass or more and 0.5% by mass or less, and more preferably 0.005% by mass or more and 0.3% by mass or less. By setting the total content within this range, the strength of the solder joint can be further improved.

Furthermore, the balance of the solder alloy is made of Sn. The solder alloy naturally comprises inevitable impurities.

As long as the solder layers 200, 200 satisfy the above configuration, solder alloys having the same alloy composition may be used, or solder alloys having different alloy compositions may be used.

Furthermore, the thickness of the solder layer 200 is preferably 10 um or more and 100 um or less. The thickness is more preferably 15 um or more and 80 um or less.

The thickness (T5) of the solder layer 200 disposed on a semiconductor element side and the thickness (T6) of the solder layer 200 disposed on a substrate side (T6) at the time of manufacturing the semiconductor package may be the same or different.

The ratio of T5 to T6 (T5:T6) in a case where the thicknesses are different is preferably 1:1 to 1:5 . A more preferred ratio thereof is 1:1.2 to 1:5 and a particularly preferred ratio thereof is 1:1.5 to 1:3.

The thickness (T7) of the bonding material 10 is preferably 30 um or more and 400 um or less. T7 is more preferably 50 um or more and 200 um or less.

The ratio between T4, T5, and T6 (T4:T5:T6) is preferably 20:1:1 to 2:1:1 . A more preferred ratio thereof is 40:3:3 to 10:3:3.

Then, the bonding material 10 having such a configuration can suppress the occurrence of cracks in the bonding portion even in a case where a particularly high temperature is loaded on the bonding portion, and can suppress the occurrence of cracks in the semiconductor element. Therefore, the bonding material 10 is suitably used for a semiconductor package, particularly a power semiconductor package.

Furthermore, the bonding material 10 can suppress the occurrence of the Ni erosion phenomenon described above.

Furthermore, in the semiconductor package manufactured using the bonding material 10, heat derived from the semiconductor element is easily discharged to the outside from the region of the bonding portion in contact with the semiconductor element, and the heat is easily conducted from the bonding portion to the substrate side, so that a load applied to the semiconductor element and the bonding portion due to the heat can be reduced. As a result, a highly reliable semiconductor package or power semiconductor package can be provided.

Furthermore, an embodiment of a method of manufacturing the bonding material 10 will be described as follows.

First, the first metal layer 104 is laminated on the upper surface and the lower surface of the core base material 102 by, for example, plating.

Next, a solder layer made of the solder alloy is formed on the surface of the first metal layer 104,104 (surface not in contact with the core base material 102). That is, for example, a solder material made of the solder alloy is laminated on the surface of the first metal layers 104,104 using a hot rolling method to form the solder layer 200,200. As a result, the second metal layers 106,106 are formed at each interface between the first metal layers 104,104 and the solder layers 200,200.

The method of forming the second metal layer 106,106 is not limited to the hot rolling method, and for example, a cold rolling method can also be used.

Furthermore, another layer may be formed between core base material 102 and first metal layers 104,104.

### (Second Embodiment)

A configuration of another embodiment (second embodiment) of a bonding material of the present invention will be described with reference to Fig. 2. That is, a bonding material 20 comprises a base material portion 110 and a solder layers 200,200. The solder layers 200,200 cover the upper surface and the lower surface of the base material portion 110.

### · Base Material Portion 110

The base material portion 110 comprises a core base material 102, a first metal layer 104, and a second metal layer 106. Specifically, the first metal layer 104 and the second metal layer 106 are provided on the upper surface of the core base material 102 in this order from the side of the core base material 102.

The solder layer 200 covering the lower surface of the base material portion 110 is laminated on the core base material 102 via a third metal layer (not illustrated).

### · Core Base Material 102

The core base material 102 preferably has the same configuration as the core base material 102 constituting the bonding material 10.

### · First Metal Layer 104

The first metal layer 104 preferably has the same configuration as the first metal layer 104 constituting the bonding material 10. However, in the bonding material 20, the first metal layer 104 is laminated only on the upper surface side of the core base material 102.

### · Second Metal Layer 106

The second metal layer 106 preferably has the same configuration as the second metal layer 106 constituting the bonding material 10. However, in the bonding material 20, the second metal layer 106 exists only on the upper surface side of the core base material 102.

The thickness (T4') of the base material portion 110 is preferably 10 um or more and 230 um or less. T4' is more preferably 50 um or more and 180 um or less.

### · Solder Layer 200

The solder layer 200 preferably has the same configuration as the solder layer 200 used for the bonding material 10. Furthermore, as a method of forming the solder layer 200, that is, as a method of forming the second metal layer 106, the same method as the method described in the first embodiment can be used.

Furthermore, the third metal layer is, for example, a precipitate (intermetallic compound) of a metal constituting the core base material 102 and an element comprised in a solder alloy when the solder layer 200 is formed on the surface (surface on which the first metal layer 104 is not formed) of the core base material 102, and is formed at an interface between the core base material 102 and the solder layer 200.

Therefore, in the second embodiment, the core base material 102 preferably consists of a metal capable of precipitating the intermetallic compound with the solder alloy. Examples of such a metal comprise a metal that can precipitate a Sn-based intermetallic compound such as a Sn-Ni-based intermetallic compound, a Sn-Ag-based intermetallic compound, a Sn-Cu-based intermetallic compound, a Sn-Au-based intermetallic compound, a Sn-Fe-based intermetallic compound, or the like.

The configuration of the third metal layer can be appropriately changed depending on the configuration of the core base material 102. That is, for example, in a case where the core base material 102 consists of Ni, the third metal layer comprises a Sn-Ni-based interalloy compound. Furthermore, in a case where the core base material 102 consists of Fe, the third metal layer comprises a Sn-Fe-based interalloy compound.

As the method of forming the third metal layer, the same method as the method of forming the second metal layer 106 can be used.

The third metal layer is not limited to the above configuration. The third metal layer may not be a precipitate (intermetallic compound) of a metal constituting the core base material 102 and an element comprised in the solder alloy, and may be formed by, for example, plating a metal or plating a solder alloy.

The thickness (T7') of the bonding material 20 is preferably 30 um or more and 430 um or less. More preferably, T7' is 80 um or more and 340 um or less.

Furthermore, a ratio between T4', T5, and T6 (T4' :T5:T6) is preferably 20:1:1 to 2:1:1. A more preferred ratio thereof is 40:3:3 to 10:3:3 at T4':T5:T6.

In a case where the semiconductor package is produced using the bonding material 20, it is preferable that the solder layer 200 existing on a side where the first metal layer 104 and the second metal layer 106 are formed is disposed on a semiconductor element side, and the solder layer 200 existing on a side where the third metal layer is formed is disposed on a substrate side.

Then, the bonding material 20 having such a configuration can suppress the occurrence of cracks in the bonding portion even in a case where a particularly high temperature is loaded on the bonding portion, and can suppress the occurrence of cracks in the semiconductor element. Therefore, the bonding material 20 is suitably used for a semiconductor package, particularly a power semiconductor package.

Furthermore, the bonding material 20 can suppress the occurrence of the Ni erosion phenomenon described above.

Furthermore, in the semiconductor package manufactured using the bonding material 20, heat derived from the semiconductor element is easily discharged to the outside from a region of the bonding portion in contact with the semiconductor element, so that the load on the semiconductor element and the bonding portion due to the heat can be reduced. As a result, a highly reliable semiconductor package or power semiconductor package can be provided.

Furthermore, an embodiment of a method of manufacturing the bonding material 20 will be described as follows.

First, the first metal layer 104 is laminated on the upper surface of the core base material 102 by, for example, plating.

Next, a solder layer made of the solder alloy is formed on the surface of the first metal layer 104 (surface not in contact with the core base material 102). That is, for example, a solder material made of the solder alloy is laminated on the surface of the first metal layer 104 using a hot rolling method. Furthermore, a solder material made of the solder alloy is laminated on the lower surface of the core base material 102 (where the first metal layer 104 does not exist) using the hot rolling method. As a result, the solder layers 200,200 are formed on each of the upper surface and the lower surface of the base material portion 110, the second metal layer 106 is formed at the interface between the first metal layer 104 and the solder layer 200, and the third metal layer is formed at the interface between the lower surface of the core base material 102 and the solder layer 200.

The method of forming the second metal layer 106 and the third metal layer is not limited to the hot rolling method, and for example, a cold rolling method can also be used.

Furthermore, another layer may be formed between core base material 102 and first metal layer 104.

The bonding material of the present invention is not limited to the above embodiments, and various modifications can be made as long as they do not impair the effect thereof.

### 2. Semiconductor Package

A semiconductor package 30 according to an embodiment of the present invention will be described with reference to Fig. 3.

The semiconductor package 30 comprises a substrate 300, a bonding portion 11, a semiconductor element 400, a wire 500, a lead frame 600, a solder portion 700, a Cu base substrate 800, a housing 900, and a molding resin 1000.

In the present embodiment, the bonding portion 11 is formed using the bonding material 10. The bonding portion 11 bonds the substrate 300 and the semiconductor element 400, and is sandwiched between the substrate 300 and the semiconductor element 400.

As the substrate 300, for example, a Cu substrate, a direct bonded copper (DBC) substrate having Cu layers on both surfaces, or a direct bonded aluminum (DBA) substrate having Al layers on both surfaces is preferably used.

The type of the semiconductor element 400 is not particularly limited. Furthermore, as the semiconductor element 400, a power semiconductor element may be used.

The wire 500 electrically connects an electrode (not illustrated) formed on a surface of the semiconductor element 400 and the lead frame 600.

The solder portion 700 joins the Cu base substrate 800 and the substrate 300, and is formed using a solder joint material. In the present embodiment, the solder joint material is used for forming the solder portion 700, but the bonding material 10 may be used instead.

The Cu base substrate 800 has heat dissipation and serves as a heat dissipation substrate.

Furthermore, the semiconductor package 30 is covered with the housing 900, and is filled with the molding resin 1000.

The semiconductor package 30 is manufactured, for example, by the following method.

That is, the bonding material 10 is disposed on the substrate 300, the semiconductor element 400 is disposed on the bonding material 10, and these components are bonded using a reflow device by applying a predetermined load.

Thereafter, the semiconductor element 400 and the lead frame 600 are bonded using the wire 500. Next, the substrate 300 on which the semiconductor element 400 is mounted and the Cu base substrate 800 are soldered and covered with the housing 900. Thereafter, the semiconductor package 30 is manufactured by filling the inside with the molding resin 1000 and curing the molding resin.

The bonding material 10, the substrate 300, and the semiconductor element 400 can be bonded by applying flux onto the substrate 300 or a surface of the bonding material 10. Furthermore, an organic acid or the like may be fluxcoated in advance on the surface of the bonding material 10.

Furthermore, for this joining, for example, formic acid reflow in a reducing atmosphere, hydrogen reflow, or the like may be used.

As described above, the semiconductor package 30 comprises the substrate 300 and the semiconductor element 400 bonded using the bonding material 10. Therefore, in the semiconductor package 30, heat derived from the semiconductor element 400 is easily discharged to the outside from the region of the bonding portion 11 in contact with the semiconductor element 400, and the heat is easily conducted from the bonding portion 11 to a side of the substrate 300. Therefore, even in a case where a high temperature is loaded on the bonding portion 11, the load on the semiconductor element 400 and the bonding portion 11 due to heat can be reduced, the occurrence of cracks in the bonding portion 11 can be suppressed, and the occurrence of cracks in the semiconductor element 400 can be suppressed.

Furthermore, in the semiconductor package 30, even in a case where Ni deposition is formed on the outermost surface of the semiconductor element 400, since the bonding portion 11 can suppress Ni erosion phenomenon, peeling of the semiconductor element 400 from the bonding portion 11 can be suppressed.

Furthermore, even in a case where the semiconductor element 400 is a power semiconductor element, that is, in a case where the semiconductor package 30 is a power semiconductor package, the bonding portion 11 can suppress the occurrence of cracks in the inside thereof, and can suppress the occurrence of cracks in the semiconductor element 400.

As described above, the semiconductor package 30 can maintain high reliability. Furthermore, the same applies to a case where the semiconductor package 30 is a power semiconductor package.

The semiconductor package of the present invention is not limited to the above embodiment, and various modifications can be made as long as they do not impair the effect.

### Examples

Hereinafter, the present invention will be described in detail with reference to Examples and Comparative Examples. The present invention is not limited to these Examples.

Solder alloys 1 to 20 shown in Table 1 were prepared. Unless otherwise specified, the unit of the numerical value in Table 1 is % by mass.

Subsequently, each test bonding material according to Examples and Comparative Examples was produced by the following method so as to have the configuration shown in Table 2.

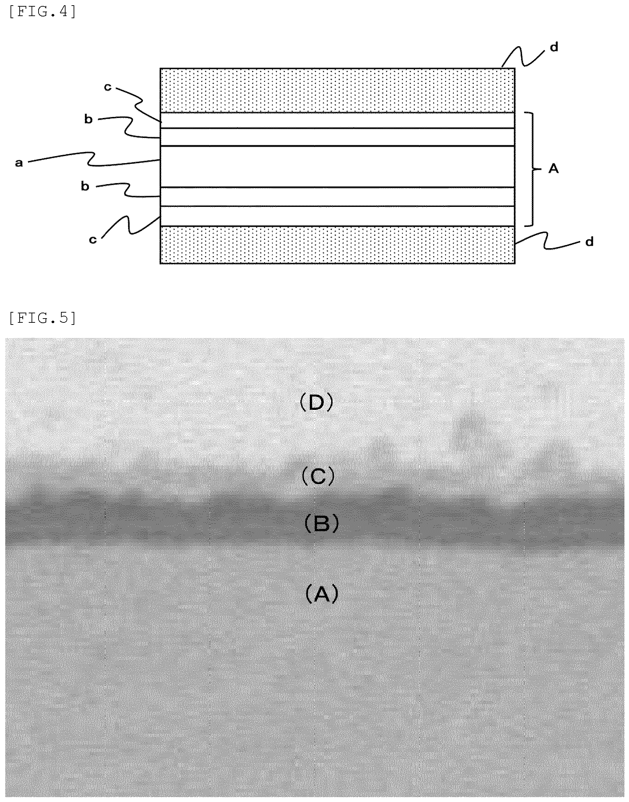

First, test bonding materials according to Examples and Comparative Examples other than Comparative Example 1 and Comparative Example 2 (see Fig. 4) were prepared by the following procedure.

That is, a first metal layers b was plated and laminated on each of the upper surface and the lower surface of a core base material a. Thereafter, the solder layer d was formed by rolling a 50 um sheet-shaped solder alloy on the upper surface and the lower surface of the core base material a with the first metal layer b interposed therebetween using a rolling mill (tabletop ϕ63 cold powder rolling mill, manufactured by Oono-roll Corporation), and a second metal layer c (intermetallic compound layer) was formed at an interface between the first metal layer a and the solder layer d.

In this way, each test bonding material including a base material portion A (including the core base material a, and the first metal layers b and the second metal layers c on the upper surface and the lower surface of the core base material a) and the solder layers d (covering the upper surface and the lower surface of the base material portion A) was prepared.

Fig. 5 illustrates a photograph of a part of a cross section of an example (Example 10) taken with an electron microscope. A region indicated by (A) is the core base material, a region indicated by (B) is the first metal layer, a region indicated by (C) is the second metal layer, and a region indicated by (D) is the solder layer.

Furthermore, in Comparative Examples 1 and 2, a sheet-shaped solder material made of each solder alloy was used as a bonding material.

The value of Ni/(Cu + Ni) of each solder alloy described in Table 1 was calculated by rounding off the value ofthe fourth decimal place according to the following Formula.

### Ni content (% by mass)/(Cu content (% by mass) + Ni content (% by mass))

Furthermore, in Table 2, the second metal layer b mainly comprises a Sn-Ni-based intermetallic compound, for those Examples in which Sn-Ni is indicated in the column of the second metal layer. Furthermore, in Table 2, the second metal layer b mainly comprises a Sn-Cu-based intermetallic compound for those Examples in which Sn-Cu is indicated in the column of the second metal layer.

Furthermore, the thickness of the core base material a was 100 um, and thicknesses of the first metal layer b and the second metal layer c were as shown in Table 2.

**[Table 1]**

| | Solder alloy 1 | Solder alloy 2 | Solder alloy 3 | Solder alloy 4 | Solder alloy 5 | Solder alloy 6 | Solder alloy 7 | Solder alloy 8 | Solder alloy 9 | Solder alloy 10 | Solder alloy 11 | Solder alloy 12 | Solder alloy 13 | Solder alloy 14 | Solder alloy 15 | Solder alloy 16 | Solder alloy 17 | Solder alloy 18 | Solder alloy 19 | Solder alloy 20 |
|---|---|---|---|---|---|---|---|---|---|---|---|---|---|---|---|---|---|---|---|---|
| Sn | Balance | Balance | Balance | Balance | Balance | Balance | Balance | Balance | Balance | Balance | Balance | Balance | Balance | Balance | Balance | Balance | Balance | Balance | Balance | Balance |
| Cu | 1 | 5 | 8 | 3 | 3 | 3 | 3 | 8 | 8 | 8 | 5 | 5 | 5 | 5 | 5 | 0.5 | | 8 | 3 | 5 |
| Sb | 10 | 10 | 10 | 15 | 20 | 25 | 30 | 10 | 10 | 10 | 10 | 10 | 10 | 10 | 10 | | 10 | 10 | 10 | 10 |
| Ni | 0.035 | 0.2 | 0.4 | 0.1 | 0.2 | 0.2 | 0.2 | 0.7 | 0.4 | 0.4 | 0.2 | 0.2 | 0.2 | 0.2 | 0.2 | | | | 0.6 | 0.2 |
| Co | 0.001 | 0.003 | 0.007 | 0.007 | 0.007 | 0.007 | 0.007 | 0.007 | 0.007 | 0.007 | 0.003 | 0.003 | 0.003 | 0.003 | 0.003 | | | | 0.006 | 0.003 |
| Ag | 0.3 | 0.3 | 0.3 | 0.3 | 0.3 | 0.3 | 0.3 | | 0.1 | 2.7 | 0.3 | 0.3 | 0.3 | 0.3 | 0.3 | 3 | | | | 3.2 |
| Al | | | | | | | | | | | 0.05 | | | | | | | | | |
| Ti | | | | | | | | | | | | 0.05 | | | | | | | | |
| Si | | | | | | | | | | | | | 0.05 | | | | | | | |
| Fe | | | | | | | | | | | | | | 0.06 | | | | | | |
| Ge | | | | | | | | | | | | | | | 0.05 | | | | | |
| Ni/(Cu + Nj) | 0.034 | 0.038 | 0.048 | 0.032 | 0.063 | 0.063 | 0.063 | 0.080 | 0.048 | 0.048 | 0.038 | 0.038 | 0.038 | 0.038 | 0.038 | - | - | - | 0.167 | 0.038 |

**[Table 2]**

| Test bonding material | Solder alloy | Core base material | Linear expansion coefficient of core base material (ppm) | Thermal conductivity of core base material (W/(m·K) | First metal layer | Thickness of first metal layer (pm) | Second metal layer | Thickness of second metal layer (µm) |
|---|---|---|---|---|---|---|---|---|
| Example 1 | Solder alloy 1 | Mo | 5.1 | 138 | Ni | 1 | Sn-Ni | 0.3 |
| Example 2 | Solder alloy 2 | Mo | 5.1 | 138 | Ni | 1 | Sn-Ni | 0.3 |
| Example 3 | Solder alloy 3 | Mo | 5.1 | 138 | Ni | 1 | Sn-Ni | 0.3 |
| Example 4 | Solder alloy 4 | Mo | 5.1 | 138 | Ni | 1 | Sn-Ni | 0.3 |
| Example 5 | Solder alloy 5 | Mo | 5.1 | 138 | Ni | 1 | Sn-Ni | 0.3 |
| Example 6 | Solder alloy 6 | Mo | 5.1 | 138 | Ni | 1 | Sn-Ni | 0.3 |
| Example 7 | Solder alloy 7 | Mo | 5.1 | 138 | Ni | 1 | Sn-Ni | 0.3 |
| Example 8 | Solder alloy 8 | Mo | 5.1 | 138 | Ni | 1 | Sn-Ni | 0.3 |
| Example 9 | Solder alloy 9 | Mo | 5.1 | 138 | Ni | 1 | Sn-Ni | 0.3 |
| Example 10 | Solder alloy 10 | Mo | 5.1 | 138 | Ni | 1 | Sn-Ni | 0.3 |
| Example 11 | Solder alloy 3 | CuMO *1 | 7.8 | 210 | Ni | 1 | Sn-Ni | 0.3 |
| Example 12 | Solder alloy 3 | Fe | 10.8 | 80 | Ni | 1 | Sn-Ni | 0.3 |
| Example 13 | Solder alloy 3 | SUS430 | 9.9 | 27 | Ni | 1 | Sn-Ni | 0.3 |
| Example 14 | Solder alloy 3 | Cu | 16.2 | 398 | Ni | 1 | Sn-Ni | 0.3 |
| Example 15 | Solder alloy 3 | Cu | 16.2 | 398 | Cu | 2 | Sn-Cu | 1.5 |
| Example 16 | Solder alloy 3 | Al | 23.7 | 237 | Ni | 10 | Sn-Ni | 0.3 |
| Example 17 | Solder alloy 11 | Mo | 5.1 | 138 | Ni | 1 | Sn-Ni | 0.3 |
| Example 18 | Solder alloy 12 | Mo | 5.1 | 138 | Ni | 1 | Sn-Ni | 0.3 |
| Example 19 | Solder alloy 13 | Mo | 5.1 | 138 | Ni | 1 | Sn-Ni | 0.3 |
| Example 20 | Solder alloy 14 | Mo | 5.1 | 138 | Ni | 1 | Sn-Ni | 0.3 |
| Example 21 | Solder alloy 15 | Mo | 5.1 | 138 | Ni | 1 | Sn-Ni | 0.3 |
| Comparative Example 1 | Solder alloy 16 | - | - | - | - | - | - | - |
| Comparative Example 2 | Solder alloy 17 | - | - | - | - | - | - | - |
| Comparative Example 3 | Solder alloy 18 | Mo | 5.1 | 138 | Ni | 1 | Sn-Ni | 0.3 |
| Comparative Example 4 | Solder alloy 19 | Mo | 5.1 | 138 | Ni | 1 | Sn-Ni | 0.3 |
| Comparative Example 5 | Solder alloy 20 | Mo | 5.1 | 138 | Ni | 1 | Sn-Ni | 0.3 |

| | | | | | | | | |
|---|---|---|---|---|---|---|---|---|
| *1 Cu35%-Mo65% | | | | | | | | |

### (1) Bondability Confirmation Test

The following tools were prepared.
· Si chip (size: 5 mm × 5 mm square, thickness: 0.3 mm, Ti deposition (0.1 um) and Ni deposition (0.5 um) sequentially laminated on bonding surface side)
· Substrate (electrolytic Ni-plated Cu plate, size: 20 mm × 20 mm square, thickness: 1 mm, thickness of Ni-plating: 5 um)

Flux (product name: EC-19S-8, manufactured by TAMURA CORPORATION) was applied onto the substrate (central portion), and the test bonding materials according to Examples and Comparative Examples were placed thereon. Then, the Si chip was placed on each test bonding material (central portion).

Then, these were reflowed under the following conditions to prepare each test bonded body including the substrate, the Si chip, and a bonding portion for bonding them.

### · Reflow Condition

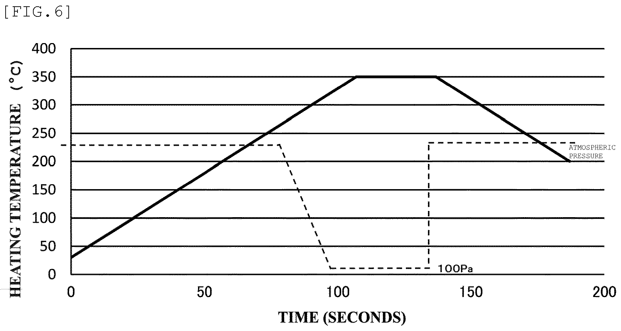

Under a mount load condition of 30g, reflow was performed using a reflow device (product name: SMT Scope SK-5000, manufactured by SANYOSEIKO CO., LTD.) based on a temperature profile condition (peak temperature: 350°C) illustrated in Fig. 6.

In the reflow, heating was started in an atmosphere having an oxygen concentration of 100 ppm and under atmospheric pressure, vacuuming was started when a reflow temperature reached 240°C, and the pressure in the reflow device was reduced to 100 Pa and this pressure was maintained. Then, after the reflow temperature reached 350°C, the pressure reduction was released after the temperature was maintained for 30 seconds, and the pressure in the reflow device was returned to atmospheric pressure to perform cooling. The change in pressure in the reflow device with the temperature profile (indicated by dotted lines) is also illustrated in Fig. 6.

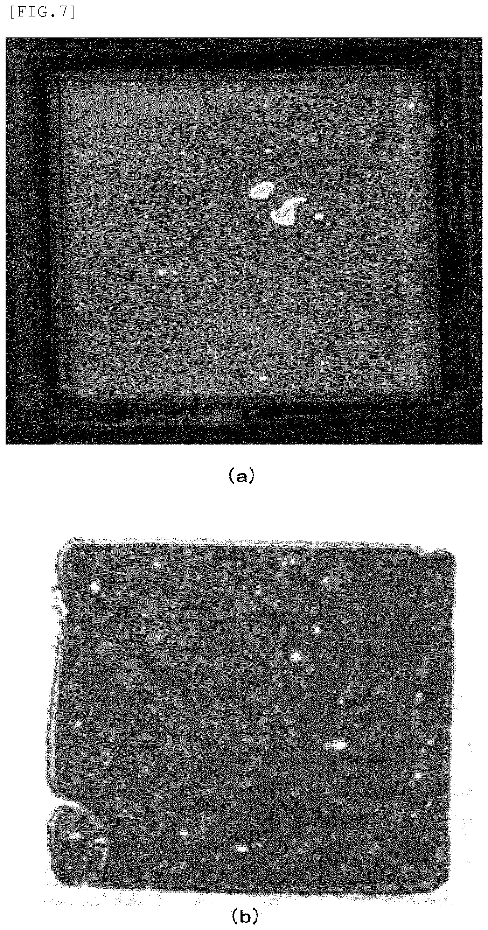

Then, a bonding interface image (See image A, Fig. 7(a)) obtained by capturing each test bonded body from a Si chip side and a bonding interface image (See image B, Fig. 7(b)) obtained by capturing each test bonded body from a substrate side were acquired using an ultrasonic microscope (product name: C-SAM Gen6, manufactured by Nordson Advanced Technology K.K.).

Furthermore, regions illustrated in the image A and the image B were defined as follows.

Region A: the region in which the Si chip and the bonding portion appear to overlap each other on the image A.

Region A': the region where the Si chip and the bonding portion are bonded in the region A

Region B: the region in which the substrate and the bonding portion appear to overlap each other on the image B.

Region B': the region where the substrate and the bonding portion are bonded to each other in the region B

Then, the sum (area X) of the area of the region A' and the area of the region B' was calculated by the following method.

That is, the sum (area Y) of the area of the region A and the area of the region B (area Y), and the sum (area Z) of areas of the non-bonded parts in the region A and the region B (white parts in the region A in Fig. 7(a) and the region B in Fig. 7(b)) were calculated, and the value obtained by subtracting the area Z from the area Y was taken as the area X.

Further, the bonding rate of each test bonded body was calculated on the basis of the following equation. Bonding rate (bonding rate 1) = area X / area Y × 100 (%)

This bonding rate was defined as a bonding rate 1, and evaluation was performed based on the following criteria. The results are shown in Table 3.
∘: Bonding rate 1 is 90% or more
Δ: Bonding rate 1 is 85% or more and less than 90%
×: Bonding rate 1 is less than 85%

### (2) Ni Erosion Confirmation Test

(1) Each test bonded body produced in the bondability confirmation test was heated at 210°C for 500 hours using a forced conversion oven (product name: DKN402, manufactured by Yamato Scientific Co., Ltd.). Then, for each test bonded body after heating, a bonding rate (bonding rate 2) was calculated in the same manner as in the (1) bondability confirmation test.

A difference between the bonding rate 1 and the bonding rate 2, that is, an increase rate of the non-bonded parts was evaluated as a Ni erosion rate on the basis of the following criteria. The results are shown in Table 3.
o: Ni erosion rate is 10% or less
Δ: Ni erosion rate is more than 10% and 20% or less
×: Ni erosion rate is more than 20%

### (3) PCT Cycle Test (Power Cycle Test)

Except for using the following tools, each test bonded body was produced under the same conditions as in the (1) bondability confirmation test.
· Heat generating (Thermal-test Engineering Group) chip (A heater/temperature sensor circuit is wired on a surface of a Si chip (size: 5 mm × 5 mm square, thickness: 0.4 mm, Ti deposition (0.1 um) and Ni deposition (2 um) are sequentially laminated on a bonding surface side.).)
· Substrate (electrolytic Ni-plated Cu plate, size: 39.2 mm × 22 mm × 3 mmt, thickness of Ni-plating: 5 um)

Each test bonded body was subjected to a PCT cycle test under the following conditions using a power cycle test device.

Each test bonded body was placed on a water-cooled cold plate.

Then, a voltage was applied to the surface of the heat generating chip of each test bonded body, and the temperature change of each test bonded body was measured by a temperature sensor.

The application to the heat generating chip was stopped (OFF) when 5 seconds had elapsed from the start (ON) of the application to the heat generating chip. The TJ of the heat generating chip surface temperature after 5 seconds from ON (= OFF) was 200°C.

Next, when 20 seconds had elapsed from OFF, the application to the heat generation chip was resumed (ON). The TJ of the surface temperature of the heat generation chip after 20 seconds from OFF (= ON) was 50°C.

The same cycle was repeated, one cycle being defined as the sequence starting from ON to OFF.

Then, the power cycle test device was stopped when the TJ reached 240°C between ON and OFF. The number of cycles (not including the cycle in which the power cycle test device was stopped) at this time point was checked and evaluated based on the following criteria. The results are shown in Table 3.
∘: 30,000 cycles or more
Δ: 20,000 cycles or more and less than 30,000 cycles
×: less than 20,000 cycles

### (4) Heat Generation Chip Cracking Confirmation Test

The surface of the heat generation chip of each test bonded body after performing the (3) PCT cycle test was observed using an ultrasonic microscope (product name: C-SAM Gen6, manufactured by Nordson Advanced Technology K.K.) to check whether or not the heat generation chip was cracked. The results (presence or absence of cracks) are shown in Table 3.

**[Table 3]**

| | (1) Bondability confirmation test | (2) Ni erosion confirmation test | (3) PCT cycle test | (4) Heat generation chip cracking confirmation test |
|---|---|---|---|---|
| Example 1 | △ | ○ | ○ | Absence |
| Example 2 | ○ | ○ | ○ | Absence |
| Example 3 | ○ | ○ | ○ | Absence |
| Example 4 | ○ | ○ | ○ | Absence |
| Example 5 | ○ | △ | ○ | Absence |
| Example 6 | △ | △ | ○ | Absence |
| Example 7 | △ | △ | ○ | Absence |
| Example 8 | △ | ○ | ○ | Absence |
| Example 9 | ○ | ○ | ○ | Absence |
| Example 10 | ○ | ○ | ○ | Absence |
| Example 11 | ○ | ○ | ○ | Absence |
| Example 12 | ○ | ○ | △ | Absence |
| Example 13 | ○ | ○ | △ | Absence |
| Example 14 | ○ | ○ | △ | Absence |
| Example 15 | △ | ○ | △ | Absence |
| Example 16 | ○ | ○ | △ | Absence |
| Example 17 | △ | ○ | ○ | Absence |
| Example 18 | △ | ○ | ○ | Absence |
| Example 19 | △ | ○ | ○ | Absence |
| Example 20 | △ | ○ | ○ | Absence |
| Example 21 | △ | ○ | ○ | Absence |
| Comparative Example 1 | ○ | x | x | Absence |
| Comparative Example 2 | ○ | x | x | Absence |
| Comparative Example 3 | ○ | x | △ | Absence |
| Comparative Example 4 | x | △ | x | Absence |
| Comparative Example 5 | △ | ○ | x | Presence |

As described above, it can be seen that the bonding portion formed using the bonding material according to Examples can suppress the occurrence of cracks in the bonding portion even in a case where a high temperature is loaded, and can maintain high bondability. Furthermore, it can be seen that these bonding materials can also suppress the occurrence of the Ni erosion phenomenon and the occurrence of cracks in the chip.

It is found that even when the bonding material comprises a base material portion as in the case of the bonding materials according to Comparative Examples 3 to 5, ifthe solder alloy constituting the solder layer does not comprise a predetermined alloy element, or the content of each alloy element is out of a predetermined range, at least one of a crack in the bonding portion, Ni erosion, and a crack in the Si chip occurs.

Therefore, the bonding material of the present invention is suitably used for a semiconductor package, particularly a power semiconductor package.

In the present Examples, each test is performed using a Si chip as a semiconductor element. However, in each of the test conditions described above, particularly in the test conditions of the (3) PCT cycle test, good results are shown even though high heat of 200°C was loaded on the heat generation chip. Therefore, from this result, it is clear that the same effect can be exhibited even when other semiconductor elements (power semiconductor elements) such as a SiC chip, a GaN chip, and a Ga₂O₃ chip and the like are used instead of the Si chip in Examples.

### Reference Signs List

- 10, 20: bonding material
- 11: bonding portion
- 30: semiconductor package
- 100, 110: base material portion
- 102: Core base material
- 104: First metal layer
- 106: Second metal layer
- 200: solder layer
- 300: substrate
- 400: semiconductor element
- 500: wire
- 600: lead frame
- 700: solder portion
- 800: Cu base substrate
- 900: housing
- 1000: molding resin

## Claims

1. A bonding material comprising a base material portion and a solder layer covering the upper surface and the lower surface of the base material portion,
wherein the base material portion comprises a core base material, and a first metal layer and a second metal layer provided on at least one surface of the core base material in this order from the side of the core base material, and
the solder layer comprises a solder alloy comprising 1% by mass or more and 8% by mass or less of Cu, 10% by mass or more and 30% by mass or less of Sb, 0.01% by mass or more and 0.5% by mass or less of Ni, and 0.001% by mass or more and 0.5% by mass or less of Co, with the balance being Sn.

2. The bonding material according to claim 1, wherein the solder alloy further comprises 0.1% by mass or more and less than 3% by mass of Ag.

3. The bonding material according to claim 1 or 2, wherein the solder alloy further comprises at least one of Al, Ti, Si, Fe, and Ge.

4. The bonding material according to any one of claims 1 to 3, wherein contents (% by mass) of Cu and Ni in the solder alloy satisfy Formula (A) below. Ni content (% by mass) / (Cu content (% by mass) + Ni content (% by mass)) < 0.1

5. The bonding material according to any one of claims 1 to 4, wherein the core base material has a linear expansion coefficient of 25 ppm/K or less.

6. The bonding material according to any one of claims 1 to 5, wherein the core base material has a thermal conductivity of 25 W/(m·K) or more.

7. The bonding material according to any one of claims 1 to 6, wherein the first metal layer consists of any one of Ni, Sn, Cu, Au, and Ag.

8. The bonding material according to any one of claims 1 to 7, wherein the second metal layer comprises at least one of a Sn-Ni-based intermetallic compound, a Sn-Ag-based intermetallic compound, a Sn-Cu-based intermetallic compound, and a Sn-Au-based intermetallic compound.

9. A semiconductor package comprising a substrate, a semiconductor element, and a bonding portion that bonds the substrate and the semiconductor element,
wherein the bonding portion is formed using a bonding material,
the bonding material comprises a base material portion and a solder layer covering the upper surface and the lower surface of the base material portion,
the base material portion comprises a core base material, and a first metal layer and a second metal layer provided on at least one surface of the core base material in this order from the side of the core base material, and
the solder layer comprises a solder alloy comprising 1% by mass or more and 8% by mass or less of Cu, 10% by mass or more and 30% by mass or less of Sb, 0.01% by mass or more and 0.5% by mass or less of Ni, and 0.001% by mass or more and 0.5% by mass or less of Co, with the balance being Sn.

10. The semiconductor package according to claim 9, wherein the solder alloy further comprises 0.1% by mass or more and less than 3% by mass of Ag.

11. The semiconductor package according to claim 9 or 10, wherein the solder alloy further comprises at least one of Al, Ti, Si, Fe, and Ge.

12. The semiconductor package according to any one of claims 9 to 11, wherein contents (% by mass) of Cu and Ni in the solder alloy satisfy Formula (A) below. Ni content (% by mass)/(Cu content (% by mass) + Ni content (% by mass)) < 0.1 ...(A)

13. The semiconductor package according to any one of claims 9 to 12, wherein the core base material has a linear expansion coefficient of 25 ppm/K or less.

14. The semiconductor package according to any one of claims 9 to 13, wherein the core base material has a thermal conductivity of 25 W/(m·K) or more.

15. The semiconductor package according to any one of claims 9 to 14, wherein the first metal layer consists of any one of Ni, Sn, Cu, Au, and Ag.

16. The semiconductor package according to any one of claims 9 to 15, wherein the second metal layer comprises at least one of an Sn-Ni-based intermetallic compound, an Sn-Ag-based intermetallic compound, an Sn-Cu-based intermetallic compound, and an Sn-Au-based intermetallic compound.
